Europäisches Patentamt

European Patent Office

Office européen des brevets

(19)

(11) Veröffentlichungsnummer: **0 291 826**
**B1**

(12) # EUROPÄISCHE PATENTSCHRIFT

(45) Veröffentlichungstag der Patentschrift:
**14.02.90**

(51) Int. Cl.⁴: **H03D 1/22**

(21) Anmeldenummer: **88107535.2**

(22) Anmeldetag: **11.05.88**

(54) **Digitaler Demodulator.**

(30) Priorität: **14.05.87 DE 3716025**

(43) Veröffentlichungstag der Anmeldung:
**23.11.88 Patentblatt 88/47**

(45) Bekanntmachung des Hinweises auf die Patenterteilung:
**14.02.90 Patentblatt 90/7**

(84) Benannte Vertragsstaaten:
**AT CH DE ES FR GB IT LI NL SE**

(56) Entgegenhaltungen:
**DE-A- 3 433 592**
**FR-A- 2 368 826**
**US-A- 4 241 451**

**EBU REVIEW-TECHNICAL, no. 204, April 1984,
pages 50-58; Brüssel, BE; S.R. ELY et al.: "Design
priniciples for VHF/FM radio recievers using the EBU
radio-data system RDS"**
**"SPECIFICATIONS OF THE RADIO DATA SYSTEM RDS
FOR VHF/FM SOUND BROADCASTING", March 1984,
tech. 3244-E, EBU Technical Centre, Brüssel, BE;
pages 1-59**

(73) Patentinhaber: **Blaupunkt-Werke GmbH,
Robert-Bosch-Strasse 200, D-3200 Hildesheim(DE)**

(72) Erfinder: **Hegeler, Wilhelm, Grosse Venedig 23,
D-3200 Hildesheim(DE)**
Erfinder: **Poschen, Dieter, Sedanstrasse 32,
D-3200 Hildesheim(DE)**

(74) Vertreter: **Eilers, Norbert, Dipl.-Phys., Blaupunkt-Werke
GmbH Robert-Bosch-Strasse 200,
D-3200 Hildesheim(DE)**

## Beschreibung

Die Erfindung betrifft einen digitalen Demodulator gemäß dem Oberbegriff des Patentanspruchs 1.

Zur Verbesserung des Verkehrsablaufs und zur Erhöhung der Verkehrssicherheit ist es schon seit längerer Zeit bekannt, über bestimmte Rundfunksender (Verkehrsfunksender) Verkehrshinweise zu geben. Um dabei dem Autofahrer das Aufsuchen des für seinen örtlichen Bereich zuständigen Verkehrsfunksenders zu erleichtern, wird ein bekanntes VRF-Kennungssystem verwendet, welches drei Kennfrequenzen verwendet, die im UKW-Bereich zusätzlich zur Nutzmodulation des FM-Verkehrsfunksenders aufmoduliert werden. Für die Senderkennung ist dabei ein 57-kHz-Träger vorgesehen, der zur Kennzeichnung aller Verkehrsfunksender dient.

Neben diesem VRF-Kennungssystem ist später das sogenannte RDS-System bekannt geworden ("Specification of the radio data system RDS", Sonderdruck der EBU Technical Centre, Brüssel, Tech. 3244 E, März 1984), welches die Übertragung einer größeren Anzahl von Informationen ermöglicht, die u.a. die Art des jeweiligen gesendeten Programmes (Programmtyp), eine Senderidentifikation, alternative Senderfrequenzen usw. betreffen.

Bei dem RDS-System erfolgt die Übertragung der RDS-Informationen in Form von digitalen Signalen auf einem Unterträger von 57 kHz über UKW-Rundfunksender, wobei eine Zweiseitenbandamplitudenmodulation des 57-kHz-Trägers (Träger wird unterdrückt) mit dem biphase-codierten Datensignal erfolgt. Durch die Biphase-Codierung erscheinen in der Nähe des Trägers nur kleine Spektrallinien, so daß eine Kompatibilität mit dem VRF-System gegeben ist. Es ist demnach grundsätzlich möglich, analoge VRF-Signale doer digitale RDS-Signale oder beide gleichzeitig zu empfangen.

Der Empfang binärer Eingangssignale mit mobilen Funkgeräten wird schon seit geraumer Zeit in der Fachwelt diskutiert, z.B. in den IEEE Transaction on Communication, Vol COM-29, Nr. 7, Juli 1981, S. 1004–1050.

Die Erfindung ging nun davon aus, daß beim Empfang eines 57-kHz-Hilfsträgers im Autoradio ein Demodulator benötigt wird, der die Rückgewinnung sowohl der gegebenenfalls empfangbaren analogen Verkehrsfunkkennungen als auch und zwar gegebenenfalls gleichzeitig der digitalen RDS-Signale gewährleistet.

Ein üblicher PLL-Demodulator ist dazu nicht geeignet, da er nur einrastet, wenn ein Träger vorhanden ist, wenn also ein VRF-Signal empfangen wird (VRF=1,57-kHz-Träger vorhanden).

In der nachveröffentlichten, älteren Patentanmeldung DE 3 624 529 A1 ist daher schon die Verwendung eines Demodulators nach dem sogenannten "Costas-Loop-Prinzip" vorgeschlagen worden, mit dem es möglich ist, auch im Falle der alleinigen Übertragung eines RDS-Signals (VRF=0) den unterdrückten Träger zu demodulieren. Dabei tritt jedoch das RDS-Signal in Abhängigkeit der Möglichkeiten VRF=1 oder VRF=0 an unterschiedlichen Schaltungsklemmen des Demodulators auf. Es ist deshalb ferner schon vorgeschlagen worden, bei dem Demodulator mit der Costas-Wirkungsweise die Steuergröße für die Ansteuerung des Oszilators in Abhängigkeit davon zu invertieren, ob ein 57-kHz-Träger vorhanden ist oder nicht, ob also VRF=1 oder VRF=0 gilt. Damit wird erreicht, daß ·das gewünschte RDS-Signal stets an derselben definierten Schaltungsklemme zur Verfügung steht, unabhängig davon, ob ein 57-kHz-Träger empfangen wird oder nicht.

Aufgrund der voranstehenden Überlegungen läßt sich also prinzipiell ein Demodulator schaltungstechnisch realisieren, der unter Berücksichtigung der Costas-Wirkungsweise und ferner unter Einbeziehung der beschriebenen Invertierung der Steuergröße für den Oszillator als RDS- und VRF-Demodulator eingesetzt werden kann. Dabei führt die unverzichtbare Voraussetzung nach Anwendung einer Costas-Schaltung in der praktischen Realisierung allerdings zu einem erheblichen Aufwand. Bei der Costas-Schaltung für die Demodulation von trägerlosen Signalen werden nämlich nach einer Mischung und nach einer Tiefpaßfilterung orthogonale Signalkomponenten miteinander multipliziert (gemischt), und das Produkt wird zur Ansteuerung des Oszillators herangezogen. Dies führt zu einem beachtlichen Schaltungsaufwand, und außerdem steht die Verwendung von Tiefpaßfiltern einer generell gewünschten Integrierbarkeit der Schaltung entgegen. Ein unter wirtschaftlichen Aspekten vernünftiger Einsatz eines solchen Demodulators ist daher nicht möglich.

Hier greift die Erfindung ein, der die Aufgabe zugrunde liegt, einen digitalen Demodulator zu schaffen, der sich durch einen einfachen Schaltungsaufbau auszeichnet und als integrierte Schaltung herstellbar ist, ohne daß dadurch die sichere Arbeitsweise des Demodulators leidet.

Dieses Ziel erreicht die Erfindung bei dem im Oberbegriff des Anspruchs 1 genannten Demodulator durch die im kennzeichnenden Teil angegebenen Merkmale.

Die Erfindung basiert auf der Überlegung, von dem Eingangssignal durch Abtastung Probenpaare zu entnehmen, wobei die Abtastzeitpunkte der einzelnen Probenpaare um 90° gegeneinander phasenverschoben sind, bezogen auf die Periode der rückgewonnenen Trägerfrequenz (Referenzfrequenz). Die so gewonnenen Probenpaare werden gleichzeitig einem Costas-Mischer zugeführt. Die weiter oben erwähnte Mischung wird bei der Erfindung also durch Abtasten des binären Eingangssignals zu definierten Zeitpunkten gebildet. Dabei können Tiefpaßfilter entfallen, so daß die Schaltung ohne weiteres als integrierte Schaltung aufgebaut werden kann. Daneben ermöglicht das Prinzip der Abtastung in vorteilhafter Weise die Verwendung an sich bekannter digitaler Schaltungsteile, wodurch der Aufbau des Demodulators insgesamt einfach und kostengünstig gestaltet werden kann.

Gemäß einer besonders vorteilhaften Weiterbildung der Erfindung wird für die Auswertung nur jedes zweite Probenpaar herangezogen, wodurch der Demodulator unempfindlich gegen eventuelle Fehler im Tastverhältnis des binären Eingangssignals wird. Somit ermöglicht die Erfindung die Realisierung eines monolithisch integrierbaren RDS-Demodulators mit sicherer Funktionsweise.

Die Probenpaare, die entstehen, wenn das binäre Eingangssignal zu verschiedenen Zeitpunkten abgetastet wird, werden kurzzeitig abgespeichert, und wenn beide Einzelproben vorliegen, werden die Probenpaare den Eingängen eines durch ein EX-OR-Glied gebildeten Costas-Mischers zugeführt, und der Ausgang des Costas-Mischers steuert die Variation der Referenzfrequenz (gegebenenfalls über einen Integrator).

Die Auswertefrequenz, durch welche vorgegeben ist, welche Probenpaare zur Auswertung herangezogen werden, wird maximal gleich der doppelten Trägerfrequenz gewählt. In diesem Fall werden alle Probenpaare zur Auswertung herangezogen. Wie oben schon erwähnt, ist es jedoch von Vorteil, die Auswertefrequenz gleich der Trägerfrequenz oder auch einer Subharmonischen davon zu wählen, so daß nicht alle Probenpaare, sondern beispielsweise nur jedes zweite Probenpaar zur Auswertung herangezogen ist. In diesem Fall spielt das Tastverhältnis des binären Eingangssignals für den Demodulationsvorgang kaum noch eine Rolle.

Weitere zweckmäßige Ausgestaltungen der Erfindung sind in den Unteransprüchen angegeben und der Beschreibung und der Zeichnung zu entnehmen.

Zum besseren Verständnis wird die Erfindung nachfolgend anhand der in der Zeichnung dargestellten Ausführungsbeispiele näher erläutert. Es zeigen:

Fig. 1 ein schematisches Teil-Schaltbild (Phasenregelschleife) eines Demodulators gemäß einer ersten Ausführungsform,

Fig. 2 ein schematisches Teil-Schaltbild eines Demodulators gemäß einer zweiten Ausführungsform,

Fig. 3 ein Diagramm zur Verdeutlichung der Probenentnahme eines binären Eingangssignals, und

Fig. 4 ein mehr detailliertes Schaltbild einer Phasenregelschleife eines Demodulators.

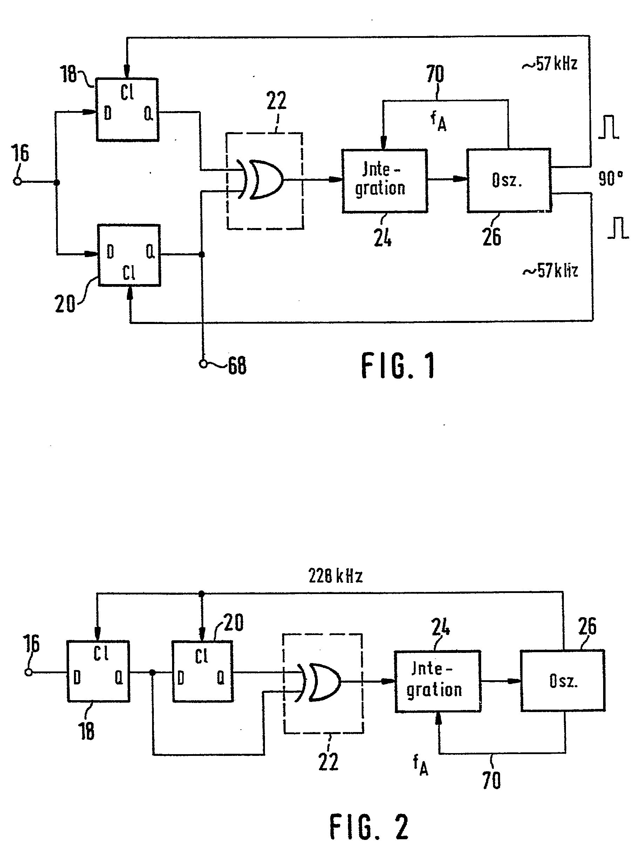

In der Schaltungsanordnung gemäß Fig. 1 liegt an einem Anschluß 16 ein binäres Eingangssignal, welches parallel zwei Abtastschaltungen 18 und 20 zugeführt ist, die durch D-Flip-Flops gebildet sind. Die beiden Abtastschaltungen 18 und 20 werden von einem steuerbaren Oszillator 26 (DCO) mit Clock-Impulsen einer Referenzfrequenz von etwa 57 kHz angesteuert. Dabei sind die der Abtastschaltung 18 einerseits und der anderen Abtastschaltung 20 andererseits zugeführten Impulse um 90° gegeneinander phasenverschoben.

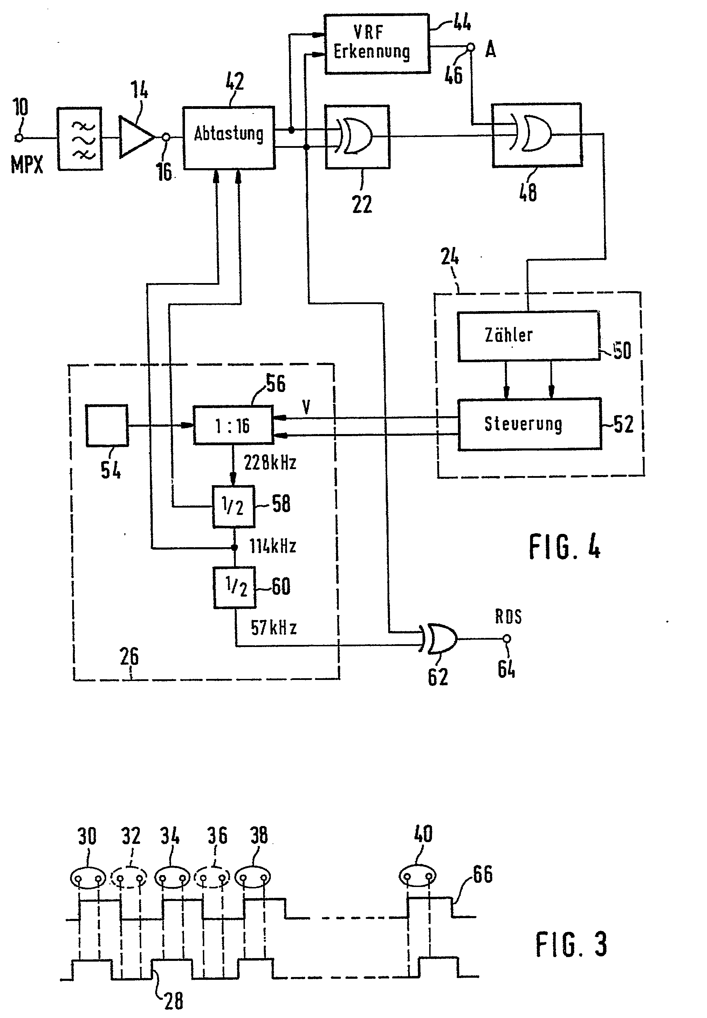

Mit Hilfe der um 90° phasenverschobenen Signale erfolgt eine Abtastung bzw. Probenentnahme des binären Eingangssignals 28 (vgl. Fig. 3). Es ist auch eine Abtastung mit der doppelten Frequenz von 114 kHz möglich, wobei dann eine Phasenverschiebung von 180° gewählt wird.

Die in Fig. 1 jeweils um 90° gegeneinander verschobenen Proben (Samples) des binären Eingangssignals 28 werden kurzzeitig gespeichert und dann gleichzeitig den Eingängen eines Costas-Mischers 22 zugeführt, welcher eine EX-OR-Verknüpfung darstellt. Der Ausgang des Costas-Mischers 22 steuert die Variation der Referenzfrequenz des Oszillators 26 über eine Integrations- und Steuerschaltung 24. Von dem Oszillator 26 wird die Integrations- und Steuerschaltung 24 über ein Rückführung 70 mit einer Auswertefrequenz $f_A$ angesteuert, die bestimmt, welche der dauernd anstehenden Probenpaare zur Auswertung herangezogen werden. Der Wert der Auswertefrequenz $f_A$ wird gleich der Trägerfrequenz oder einer Subharmonischen davon gewählt.

Die Integrations- und Steuerschaltung 24 beinhaltet einen Zähler 50 (vgl. Fig. 4; Up Down-Zähler) und je nach dem, ob am Eingang der Integrations- und Steuerschaltung 24 eine "1" oder eine "0" anliegt, wird der Inhalt des Zählers dekrementiert (Zählerinhalt wird um "1" erniedrigt) oder inkrementiert (Zählerinhalt wird um "1" erhöht), wobei die Dekremention oder Inkremention des Integratorinhaltes durch die Auswahlfrequenz vorgegeben wird.

Die Schaltungsanordnung gemäß Fig. 2 unterscheidet sich von Fig. 1 dadurch, daß die beiden Abtastschaltungen 18 und 20 in Reihe angeordnet sind, so daß ihnen das binäre Eingangssignal nicht gleichzeitig, sondern nacheinander zugeführt wird. Die Probenentnahme erfolgt hier mit der Referenzfrequenz von 228 kHz, wobei die Signale - ohne Phasenverschiebung - gleichzeitig den beiden Abtastschaltungen 18 und 20 zugeführt werden.

Auch in Fig. 2 gelangen wiederum jeweils zwei um 90° gegeneinander verschobene Proben des binären Eingangssignals nach einer kurzzeitigen Speicherung an die Eingänge des Costas-Mischers 22, an den sich die Integrations- und Steuerschaltung 24 und der Oszillator 26 anschließen.

Anhand des Diagramms in Fig. 3 wird die Abtastung des binären Eingangssignals 28 bzw. die Probenentnahme näher verdeutlicht. Oberhalb des binären Eingangssignals ist die Referenzfrequenz 66 dargestellt und durch die mit durchgezogenen oder gestrichelten Linien umgebenen Punkte-Paare sind die Probenpaare 30 - 40 angedeutet, wobei jeder Punkt eine Einzelprobe darstellt.

Je nach Verlauf des binären Eingangssignals 28 können die Einzelproben "0" oder "1" sein.

Bei den dargestellten Probenpaaren 30 - 38 sind die Einzelproben jeweils gleich (entweder jeweils "1" oder jeweils "0"). Demgegenüber sind die Einzelproben des Probenpaares 40 ungleich; die erste linke Einzelprobe ist "0", und die rechte zweite Einzelprobe ist "1".

Das binäre Eingangssignal wird also durch Probenpaare 30 - 40 zu verschiedenen Zeitpunkten abgefragt, wobei die einzelnen Proben um 90° gegeneinander phasenverschoben sind. Am Eingang der Integrations- und Steuerschaltung 24 steht somit die EX-OR-Verknüpfung der jeweils letzten beiden Proben. Bei Gleichheit der beiden Proben erfolgt eine Korrektur (Frequenzregelung) in einer ersten Richtung, und bei Ungleichheit der beiden Proben wird eine Korrektur in einer anderen entgegengesetzten Richtung vorgenommen.

Für jedes Probenpaar gibt es nämlich genau zwei Möglichkeiten: a) Gleiche Polarität (die Proben stammen sozusagen aus derselben "Halbwelle"); b) Ungleiche Polarität (zwischen den Proben liegt ein "Null-Durchgang" bzw. eine Flanke des Eingangssignals). Nur diese Information - gleich oder ungleich - wird von dem EX-OR-Glied des Costas-Mischers 22 weitergegeben. Die daraus langfristig resultierende Frequenz- bzw. Phasenkorrektur bewirkt, daß eine der Abtastfolgen auf die Eingangsflanken synchronisiert wird, wobei genauer gesagt um diesen synchronisierten Zustand kleine Regelschwingungen erfolgen; es wird also immer in Richtung stabiler Zustand geregelt.

Bei Vorhandensein eines VRF- und/oder RDS-Signals kann das binäre Eingangssignal (in Folge einer Vorselektion und Begrenzung) für kurze Zeiten als ein Rechtecksignal mit einer ungefähren Frequenz von 57 kHz dargestellt werden. Die RDS-Information äußert sich darin als Phasenmodulation, und mit der voranstehend beschriebenen Regelung kann in Fig. 1 an der Ausgangsklemme 68 ein gewonnenes RDS-Signal zur weiteren Verarbeitung und zur Gewinnung der eigentlichen RDS-Informationen abgenommen werden.

Grundsätzlich kann jedes Probenpaar 30 - 40 in Fig. 3 für die Auswertung und für die Regelung herangezogen werden, allerdings läßt sich dabei nicht ausschließen, daß in der Regelschleife ein sogenannter "Toter Gang" über gewisse Zeiträume hinweg entsteht. Ein solcher toter Gang kann sich einstellen, wenn die bei Auswertung aller Probenpaare 30 - 40 gewonnenen Auswerteinformationen sich paarweise jeweils widersprechen bzw. sich in ihrer Wirkung aufheben.

Man verzichtet deshalb mit Vorteil auf die Auswertung jeder zweiten Flankeninformation (oder mehr), indem die Auswertefrequenz $f_A$ gleich 57 kHz oder einer Subharmonischen davon gewählt wird.

Auf diese Weise werden in Fig. 3 nur die mit einer durchgezogenen Linie gekennzeichneten Probenpaare 30, 34, 38 usw. zur Auswertung herangezogen. Dann arbeitet die Regelung, solange die "1"- bzw. "0"- Zeiten des binären Eingangssignals 28 länger als ein Viertel der Periode sind. Ein toter Gang in der Regelschleife ist damit vermieden, und das Tastverhältnis des binären Eingangssignals spielt kaum noch eine Rolle.

In jedem Fall besteht die grundlegende Wirkungsweise darin, die entnommenen Probenpaare einer EX-OR-Verknüpfung zu unterwerfen und das Verknüpfungsergebnis zur Steuerung des Oszillators 26 heranzuziehen. Auf diese Weise wird eine digitale Costas-Schaltung für RDS- und/oder VRF-Signale geschaffen.

In Fig. 4 ist ein mehr detailliertes Schaltbild dargestellt. An einer Eingangsklemme 10 liegt in üblicher Weise ein an sich bekanntes MPX-Signal an, welches ein aufmoduliertes VRF-Signal und/oder ein aufmoduliertes RDS-Signal enthält. Durch einen Bandpaß 12 (57 kHz-Filter) wird der Frequenzbereich um 57 kHz herausgefiltert. An den Bandpaß 12 schließt sich ein Komparator 14 an, dessen binäre Signale am Anschluß 16 (vgl. Fig. 1 und 2) zur Abtastung 42 gelangen.

An die Abtastung 42 schließen sich der Costas-Mischer 22 sowie eine VRF-Erkennungsschaltung 44 an, an dessen VRF-Ausgang 46 der VRF-Pegel A abgegriffen werden kann.

Bei Vorhandensein eines VRF-Signals bzw. des 57 kHz-Trägers ist A = 1, während A = 0 bei fehlendem 57 kHz-Träger gilt. Der VRF-Pegel A wird benötigt, um an einer eindeutigen bestimmten Ausgangsklemme 64 ein RDS-Signal zur weiteren Verarbeitung abgreifen zu können, und zwar unabhängig davon, ob A = 1 oder A = 0 gilt.

Die binäre Steuergröße des Costas-Mischers 22 speist den Up/Down-Eingang des Integrator-Zählers 50, und zwar unter Zwischenschaltung eines EX-OR-Gliedes (Inverter) 48, dessen anderer Eingang von der VRF-Erkennungsschaltung 44 gesteuert wird, und welches gegebenenfalls eine Invertierung bewirkt.

Der Integrator-Zähler 50 und eine Steuerschaltung 52 bilden zusammen die zuvor schon erwähnte Integrations- und Steuerschaltung 24 zur Ansteuerung des Oszillators 26. Dieser ist als digitaler "VCO" (DCO) Oszillator ausgebildet, der in an sich bekannter Weise aus einem hochfrequenten Festoszillator 54 mit einem nachgeschalteten steuerbaren Frequenzteiler 56 bestehen kann. Bei der Ansteuerung des Frequenzteilers 56 durch die Steuerschaltung 52 bewirkt ein "Carry" einen Impuls der Dauer 1/228 kHz, wenn zuvor der Integrator-Zähler 50 die Mitte passiert hat (Set Ready FF). Ready FF wird durch einen Impuls V zurückgesetzt.

Der steuerbare Frequenzteiler 56 wird von dem Festoszillator 54 mit der Frequenz 3,648 MHz angesteuert. Zunächst erfolgt eine Teilung durch "16", so daß 228 kHz entstehen, aus denen mit Hilfe von Frequenzteilern 58 und 60 zwei 114 kHz-Folgen als orthogonale Clockfolgen abgeleitet werden. Am Ausgang 64 eines EX-OR-Gliedes 62 steht in definierter Weise ein RDS-Signal zur weiteren Aufbereitung mittels einer an sich bekannten RDS-Kennung an.

**Patentansprüche**

1. Digitaler Demodulator zur Demodulation eines binären Eingangssignals, das ein erstes, einen Träger enthaltendes amplitudenmoduliertes Signal (VRF-Signal) und/oder ein zweites amplitudenmoduliertes Signal (RDS-Signal) mit unterdrücktem Träger aufweist, wobei die beiden Träger frequenzgleich um 90° gegeneinander phasenverschoben sind, mit einem steuerbaren Oszillator (DCO) zur Erzeugung einer Referenzfrequenz, und mit einem Mischer, dessen Ausgangssignal zu einem Steuersignal für den Oszillator verarbeitet wird, wobei das Steuersignal für den Oszillator in Abhängigkeit des VRF-Pegels invertiert wird, dadurch gekennzeichnet, daß von dem Eingangssignal (28) Probenpaare (30–40) mittels zwei durch D-Flip-Flops (18, 20) gebildete Abtastschaltungen entnommen werden, die jeweils durch zwei Einzelproben gebildet werden, welche – bezogen auf die Periode der rückgewonnenen Trägerfrequenz (Referenzfrequenz) – um 90°
gegeneinander verschoben sind, daß die Probenpaare (30–40) gleichzeitig dem Mischer zugeführt
sind, wobei jeweils ein Eingang des Mischers unmittelbar mit jeweils einem Ausgang der beiden Abtastschaltungen verbunden ist, und daß der Mischer
als Costas-Mischer (22) ausgebildet ist.

2. Demodulator nach Anspruch 1,
dadurch gekennzeichnet,
daß dem Costas-Mischer (22) eine Integrations-
und Steuerschaltung (24) nachgeschaltet ist, dessen Ausgang den Oszillator (26) ansteuert.

3. Demodulator nach Anspruch 2,
dadurch gekennzeichnet,
daß die Auswahl der auszuwertenden Probenpaare
(30 - 40) durch Ansteuerung der Integrations- und
Steuerschaltung (24) mit einer Auswertefrequenz
(FA) von maximal 114 kHz erfolgt.

4. Demodulator nach Anspruch 2,
dadurch gekennzeichnet,
daß die Auswahl der auszuwertenden Probenpaare
(30 - 40) durch Ansteuerung der Integration und
Steuerschaltung (24) mit einer Auswertefrequenz
(FA) von 57 kHz oder einer Subharmonischen davon erfolgt, so daß nur ein Teil der Probenpaare
(30 - 40) zur Auswertung herangezogen ist.

5. Demodulator nach einem der vorhergehenden
Ansprüche 1 - 4,
dadurch gekennzeichnet,
daß zwei parallel betriebene Abtastschaltungen (18,
20) vorgesehen sind, deren vom Oszillator (26)
stammende und für die Abtastung herangezogene
Referenzfrequenz etwa 57 kHz betragen und die
um 90° gegeneinander phasenverschoben sind.

6. Demodulator nach einem der vorhergehenden
Ansprüche 1–4,
dadurch gekennzeichnet,
daß zwei parallel betriebene Abtastschaltungen (18,
20) vorgesehen sind, deren vom Oszillator (26)
stammenden und für die Abtastung herangezogenen Referenzfrequenzen etwa 114 kHz betragen
und um 180° gegeneinander phasenverschoben
sind.

7. Demodulator nach einem der vorhergehenden
Ansprüche 1–6,
dadurch gekennzeichnet,
daß bei Gleichheit der Einzelproben eines Probenpaares (30 - 40) eine Frequenzregelung in einer ersten Richtung und bei Ungleichheit der Einzelproben eines Probenpaares (30 - 40) eine Frequenzregelung in einer zweiten entgegengesetzten Richtung
erfolgt.

8. Demodulator nach einem der vorhergehenden
Ansprüche 1–7,
dadurch gekennzeichnet,
daß eine schnelle VRF-Erkennungsschaltung (44)
mit einem das Vorhandensein eines VRF-Pegels (A)
repräsentierenden VRF-Ausgang vorgesehen ist,
um das Steuersignal für den Oszillator (26) zu invertieren, mit der Folge, daß an einer eindeutigen
Ausgangsklemme (68) ein Signal für die RDS-Verarbeitung entnehmbar ist.

**Revendications**

1. Démodulateur numérique pour démoduler un signal d'entrée binaire qui comprend un premier signal
modulé en amplitude avec une porteuse (signal
VRF) et/ou un second signal modulé en amplitude
(signal RDS) dont la porteuse a été supprimée, les
deux porteuses étant de même fréquence mais déphasées de 90°, ainsi qu'un oscillateur commandé
(DCO) pour créer une fréquence de référence et
un mélangeur dont le signal de sortie est traité comme signal de commande de l'oscillateur, ce signal de
commande de l'oscillateur étant inversé en fonction
du niveau VRF, démodulateur caractérisé en ce
que du signal d'entrée (28) on prend des paires
d'échantillons (30–40) à l'aide de circuits de détection formés par deux Flip-Flop D (18, 20), paires
d'échantillons formées chaque fois de deux échantillons distincts qui, rapportés à la période de la fréquence de porteuse, récupérée (fréquence de référence) sont décalés de 90°, et en ce que les paires
d'échantillons (30–40) sont appliquées simultanément au mélangeur, une entrée du mélangeur étant
reliée directement, de manière respective, à une
sortie des deux circuits de détection et en ce que le
mélangeur est un mélangeur Costas 22.

2. Démodulateur selon la revendication 1, caractérisé en ce que le mélangeur Costas (22) est suivi
par un circuit d'intégration et de commande (24)
dont la sortie commande l'oscillateur (26).

3. Démodulateur selon la revendication 2, caractérisé en ce que le choix des paires d'échantillons à
exploiter (30–40) est assuré par la commande du circuit d'intégration et de commande (24) à l'aide d'une
fréquence d'exploitation (fA) égale au maximum à 114
kHz.

4. Démodulateur selon la revendication 2, caractérisé en ce que le choix de la paire d'échantillons à
exploiter (30–40) est assuré par la commande du circuit d'intégration et de commande (24) à l'aide d'une
fréquence d'exploitation (fA) de 57 kHz ou d'une
sous-harmonique de cette fréquence de façon que
seulement une partie des paires d'échantillons (30–
40) ne serve à l'exploitation.

5. Démodulateur selon l'une des revendications 1
à 4 précédentes, caractérisé par deux circuits de
détection (18, 20) fonctionnant en parallèle, dont la
fréquence de référence, fournie par l'oscillateur
(26) et servant à la détection, est de l'ordre de 57
kHz, qui sont déphasées de 90°.

6. Démodulateur selon l'une des revendications
précédentes 1–4, caractérisé en ce qu'il comporte
deux circuits de détection (18, 20) fonctionnant en
parallèle et dont les fréquences de référence fournies par l'oscillateur (26) et servant à la détection
sont environ égales à 114 kHz et sont déphasées de
180°.

7. Démodulateur selon l'une des revendications
précédentes 1–6, caractérisé en ce qu'en cas
d'égalité des échantillons distincts d'une paire
d'échantillons (30–40) la régulation de la fréquence
se fait dans une première direction et en cas de
différence des échantillons distincts d'une paire
d'échantillons (30–40) la régulation de la fréquence se fait dans une deuxième direction opposée à la précédente.

8. Démodulateur selon l'une des revendications précédentes 1–7, caractérisé par un circuit de reconnaissance rapide VRF (44) avec une sortie VRF représentant la présence d'un niveau VRF (A) pour inverser le signal de commande destiné à l'oscillateur (26) avec pour conséquence l'envoi d'un signal à une borne de sortie (68) sans équivoque pour le traitement RDS.

**Claims**

1. Digital demodulator for demodulating a binary input signal which exhibits a first amplitude-modulated signal (TP signal) containing a carrier and/or a second amplitude-modulated signal (RDS signal) with suppressed carrier, the two carriers being phase-shifted by 90° with respect to one another at the same frequency, comprising a controllable oscillator (DCO) for generating a reference frequency, and comprising a mixer, the output signal of which is processed to form a control signal for the oscillator, the control signal for the oscillator being inverted in dependence on the TP level, characterized in that from the input signal (28), sample pairs (30–40) are taken by means of two sampling circuits formed by D-type flip-flops (18, 20) which are in each case formed by two single samples which – referred to the period of the recovered carrier frequency (reference frequency) – are shifted by 90° with respect to one another, in that the sample pairs (30–40) are simultaneously supplied to the mixer, one input of the mixer in each case being directly connected to in each case one output of the two sampling circuits, and in that the mixer is constructed as a Costas mixer (22).

2. Demodulator according to Claim 1, characterized in that the Costas mixer (22) is followed by an integration and control circuit (24) the output of which drives the oscillator (26).

3. Demodulator according to Claim 2, characterized in that the sample pairs (30–40) to be evaluated are selected by driving the integration and control circuit (24) with an evaluating frequency ($F_A$) of 114 kHz at a maximum.

4. Demodulator according to Claim 2, characterized in that the sample pairs (30–40) to be evaluated are selected by driving the integration and control circuit (24) with an evaluating frequency ($F_A$) of 57 kHz or a subharmonic thereof, so that only a part of the sample pairs (30–40) is utilized for the evaluation.

5. Demodulator according to one of the preceding Claims 1–4, characterized in that two sampling circuits (18, 20) operated in parallel are provided, the reference frequency of which, originates from the oscillator (26) and is used for the sampling, are (sic) about 57 kHz and which are (sic) phase-shifted by 90° with respect to one another.

6. Demodulator according to one of the preceding Claims 1–4, characterized in that two sampling circuits (18, 20), which are operated in parallel, are provided, the reference frequencies of which, which originate from the oscillator (26) and are used for the sampling, are about 114 kHz and are phase-shifted by 180° with respect to one another.

7. Demodulator according to one of the preceding Claims 1–6, characterized in that with equality of the single samples of a sample pair (30–40), a frequency control is effected in a first direction and with inequality of the single samples of a sample pair (30–40), a frequency control is effected in a second opposite direction.

8. Demodulator according to one of the preceding Claims 1–7, characterized in that a fast TP detection circuit (44) with a TP output representing the presence of a TP level (A) is provided in order to invert the control signal for the oscillator (26), with the consequence that a signal for the RDS processing can be picked up at an unambiguous output terminal (68).

FIG. 1

FIG. 2

FIG. 4

FIG. 3